# EUROPEAN PATENT APPLICATION

(11) **EP 4 535 083 A1**
(43) Date of publication of application: **09.04.2025**
(21) Application number: 23202227.7
(22) Date of filing: 06.10.2023
(51) Int. Cl.: G03F 7/20

(54) **A METHOD OF REFURBISHING A SUBSTRATE SUPPORT**

(71) Applicant: ASML Netherlands B.V., 5500 AH Veldhoven (NL)
(72) Inventor: KEMPEN, Antonius, Theodorus, Wilhelmus, 5500 AH Veldhoven (NL); BALDUS, Oliver, 12347 Berlin (DE)
(74) Representative: ASML Netherlands B.V.

(57) **Abstract**

A method of refurbishing a substrate support, the substrate support comprising: a first surface, configured to support a substrate; and a second surface, opposite to the first surface. The method comprises: depositing a material on the second surface to form a coating layer which increases a thickness of the substrate support; and removing material from the first surface.

## Description

### FIELD

The present invention relates to a method of refurbishing a substrate support. The method may be applied to a substrate support, which has been used by a lithographic apparatus. The lithographic apparatus may be an exposure apparatus used to expose a substrate or a metrology apparatus used for inspection of a substrate. The method may be applied during a manufacturing process of the substrate support.

### BACKGROUND

A lithographic exposure apparatus is a machine constructed to apply a desired pattern onto a substrate. A lithographic apparatus can be used, for example, in the manufacture of integrated circuits (ICs). A lithographic exposure apparatus may, for example, project a pattern (also often referred to as "design layout" or "design") of a patterning device (e.g., a mask) onto a layer of radiation-sensitive material (resist) provided on a substrate (e.g., a wafer).

As semiconductor manufacturing processes continue to advance, the dimensions of circuit elements have continually been reduced while the amount of functional elements, such as transistors, per device has been steadily increasing over decades, following a trend commonly referred to as 'Moore's law'. To keep up with Moore's law the semiconductor industry is chasing technologies that enable to create increasingly smaller features. To project a pattern on a substrate a lithographic exposure apparatus may use electromagnetic radiation. The wavelength of this radiation determines the minimum size of features which are patterned on the substrate. Typical wavelengths currently in use are 365 nm (i-line), 248 nm, 193 nm, and 13.5 nm. A lithographic exposure apparatus, which uses extreme ultraviolet (EUV) radiation, having a wavelength within a range of 4 nm to 20 nm, for example 6.7 nm or 13.5 nm, may be used to form smaller features on a substrate than a lithographic exposure apparatus which uses, for example, radiation with a wavelength of 193 nm.

During the projection of a pattern or an inspection of the pattern within a lithographic apparatus, a substrate support is typically used to hold the substrate. In particular, the substrate is supported by a first surface of the substrate support. After multiple such uses, the substrate support may be worn at the first surface and unsuitable for further use. The substrate can be reconditioned or refurbished for further use. Known methods of refurbishing the substrate support result in a reduction of the thickness of the substrate support by removal of material in order to remove worn material. In order to maintain or restore flatness, material from non-worn areas adjacent to worn material may also be removed.

A lithographic apparatus is sensitive to the substrate support thickness. After multiple refurbishments, for example three, the thickness of the support table may be reduced such that further refurbishment of the substrate support would render the substrate support too thin to be compatible with the lithographic apparatus, e.g., the exposure apparatus. Thus, known methods of refurbishing substrate supports result in substrate supports being discarded after a finite number of refurbishments.

It may be desirable to provide an apparatus that obviates or mitigates one or more problems associated with the prior art.

### SUMMARY

According to a first aspect there is provided a method of refurbishing a substrate support, the substrate support comprising: a first surface, configured to support a substrate; and a second surface, opposite to the first surface; the method comprising: depositing a material on the second surface to form a coating layer which increases a thickness of the substrate support; and removing material from the first surface.

Advantageously, the deposition of a material on the second surface compensates for material removal from the first surface, restoring the thickness of the substrate support, enabling its further use. Deposition of a material at the first surface is difficult due to demanding requirements with respect to surface flatness and finish.

The material may be removed from the first surface after depositing a material on the second surface.

The method may further comprise depositing a material on the first surface to form a further coating layer which increases a thickness of the substrate support.

The coating layer may be at least 1 µm thick.

The coating layer may be at least 3 µm thick.

The coating layer may be up to 300 µm thick.

The second surface may be partially defined by projections, configured to support the substrate support.

The first surface may also be partially defined by projections, configured to support the substrate.

The material may be deposited selectively on the projections of the second surface.

The material may be deposited uniformly over the second surface.

The method may further comprise selectively subtracting portions of the coating layer.

Removing material from the first surface may comprise fine-lapping the first surface.

The method may comprise depositing a diamond-like carbon coating, a chromium nitride coating, or a diamond coating on at least a portion of the first surface.

The deposited coating may be up to around 1000 nm thick.

The method may comprise depositing a carbon-based coating on at least a portion of the first surface.

The method may comprise depositing a wear-resistant material having a hardness of more than 6 GPa on at least a portion of the first surface. The wear-resistant material may have a hardness of more than 20 GPa.

The method may further comprise fine-lapping the coating layer.

The material deposited on the second surface to form a coating layer may comprise the same material as the second surface of the substrate support.

The material deposited on the second surface to form a coating layer may be Silicon Carbide.

Advantageously, Silicon Carbide adheres to the second surface well and has high polishability.

The material may be Silicon Dioxide or Silicon Nitride.

The method may comprise depositing a ceramic coating having a coefficient of thermal expansion up to a value similar to silicon.

The material may be deposited by physical vapour deposition.

The material may be deposited by sputter deposition.

Sputtering deposition can be performed at low temperatures, and reduces thermal stresses induced in the substrate support.

The material may be deposited by chemical vapour deposition.

The method may further comprise flattening the first surface by ion beam figuring or by reactive ion etching after deposition of the wear-resistant material.

According to a second aspect there is provided a substrate support that is refurbished according to the disclosed method.

The substrate support may be a refurbished substrate support.

### BRIEF DESCRIPTION OF THE DRAWINGS

Embodiments of the invention will now be described, by way of example only, with reference to the accompanying schematic drawings, in which:
- Figure 1 depicts a schematic overview of a lithographic apparatus;
- Figure 2 depicts a schematic cross section through part of a substrate support, a positioner and a substrate as shown in Figure 1;
- Figure 3 depicts a method according to an embodiment of the present disclosure;
- Figure 4A depicts a schematic cross section through a used substrate support;
- Figure 4B depicts a schematic cross section through the substrate support shown in Figure 4A after material removal;
- Figure 4C depicts a schematic cross section through the substrate support shown in Figure 4A and 4B in a refurbished state;
- Figure 5A depicts a schematic cross section through a used substrate support below a minimum thickness;
- Figure 5B depicts a schematic cross section through the substrate support shown in Figure 5A after material deposition;
- Figure 5C depicts a schematic cross section through the substrate support shown in Figure 5A and 5B after material removal; and
- Figure 5D depicts a schematic cross section through the substrate support shown in Figures 5A-C in another refurbished state.

### DETAILED DESCRIPTION

In the present document, the terms "radiation" and "beam" are used to encompass all types of electromagnetic radiation, including deep ultraviolet radiation (DUV) (e.g., with a wavelength of 365, 248, 193, 157 or 126 nm) and EUV (extreme ultra-violet radiation, e.g., having a wavelength in the range of about 5-100 nm).

The term "reticle", "mask" or "patterning device" as employed in this text may be broadly interpreted as referring to a generic patterning device that can be used to endow an incoming radiation beam with a patterned cross-section, corresponding to a pattern that is to be created in a target portion of the substrate. The term "light valve" can also be used in this context. Besides the classic mask (transmissive or reflective, binary, phase-shifting, hybrid, etc.), examples of other such patterning devices include a programmable mirror array and a programmable LCD array.

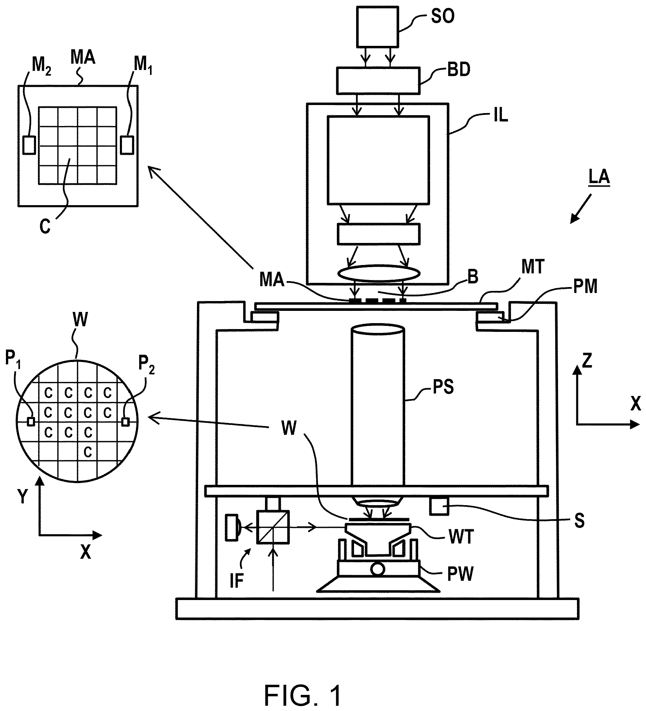

Figure 1 schematically depicts a lithographic apparatus LA - an example of a lithographic exposure apparatus. The lithographic apparatus LA includes an illumination system (also referred to as illuminator) IL configured to condition a radiation beam B (e.g., UV radiation, DUV radiation or EUV radiation), a mask support (e.g., a mask table) MT constructed to support a patterning device (e.g., a mask) MA and connected to a first positioner PM configured to accurately position the patterning device MA in accordance with certain parameters, a substrate support (which may be referred to as a clamp) WT constructed to hold a substrate (e.g., a resist coated wafer) W. The substrate support WT may form part of a substrate stage which includes sensors and associated electronics. The substrate support is connected to a second positioner PW configured to accurately position the substrate support in accordance with certain parameters, and a projection system (e.g., a refractive projection lens system) PS configured to project a pattern imparted to the radiation beam B by patterning device MA onto a target portion C (e.g. comprising one or more dies) of the substrate W.

In operation, the illumination system IL receives a radiation beam from a radiation source SO, e.g. via a beam delivery system BD. The illumination system IL may include various types of optical components, such as refractive, reflective, magnetic, electromagnetic, electrostatic, and/or other types of optical components, or any combination thereof, for directing, shaping, and/or controlling radiation. The illuminator IL may be used to condition the radiation beam B to have a desired spatial and angular intensity distribution in its cross section at a plane of the patterning device MA.

The term "projection system" PS used herein should be broadly interpreted as encompassing various types of projection system, including refractive, reflective, catadioptric, anamorphic, magnetic, electromagnetic and/or electrostatic optical systems, or any combination thereof, as appropriate for the exposure radiation being used, and/or for other factors such as the use of an immersion liquid or the use of a vacuum. Any use of the term "projection lens" herein may be considered as synonymous with the more general term "projection system" PS.

The lithographic apparatus LA may be of a type wherein at least a portion of the substrate may be covered by a liquid having a relatively high refractive index, e.g., water, so as to fill a space between the projection system PS and the substrate W - which is also referred to as immersion lithography. More information on immersion techniques is given in US6952253, which is incorporated herein by reference.

The lithographic apparatus LA may also be of a type having two or more substrate supports WT (also named "dual stage"). In such "multiple stage" machines, the substrate supports WT may be used in parallel, and/or steps in preparation of a subsequent exposure of the substrate W may be carried out on the substrate W located on one of the substrate support WT while another substrate W on the other substrate support WT is being used for exposing a pattern on the other substrate W.

In addition to the substrate support WT, the lithographic apparatus LA may comprise a measurement stage. The measurement stage is arranged to hold a sensor and/or a cleaning device. The sensor may be arranged to measure a property of the projection system PS or a property of the radiation beam B. The measurement stage may hold multiple sensors. The cleaning device may be arranged to clean part of the lithographic apparatus, for example a part of the projection system PS or a part of a system that provides the immersion liquid. The measurement stage may move beneath the projection system PS when the substrate support WT is away from the projection system PS.

In operation, the radiation beam B is incident on the patterning device, e.g. mask, MA which is held on the mask support MT, and is patterned by the pattern (design layout) present on patterning device MA. Having traversed the mask MA, the radiation beam B passes through the projection system PS, which focuses the beam (at a focal plane) onto a target portion C of the substrate W. With the aid of the second positioner PW and a position measurement system IF, the substrate support WT can be moved accurately, e.g., so as to position different target portions C in the path of the radiation beam B at a focused and aligned position. Similarly, the first positioner PM and possibly another position sensor (which is not explicitly depicted in Figure 1) may be used to accurately position the patterning device MA with respect to the path of the radiation beam B. Patterning device MA and substrate W may be aligned using mask alignment marks M1, M2 and substrate alignment marks P1, P2. Although the substrate alignment marks P1, P2 as illustrated occupy dedicated target portions, they may be located in spaces between target portions. Substrate alignment marks P1, P2 are known as scribe-lane alignment marks when these are located between the target portions C.

To clarify the invention, a Cartesian coordinate system is used. The Cartesian coordinate system has three axes, i.e., an x-axis, a y-axis and a z-axis. Each of the three axis is orthogonal to the other two axes. The x-axis and the y-axis define a horizontal plane, whereas the z-axis is in a vertical direction. The Cartesian coordinate system is not limiting the invention and is used for clarification only.

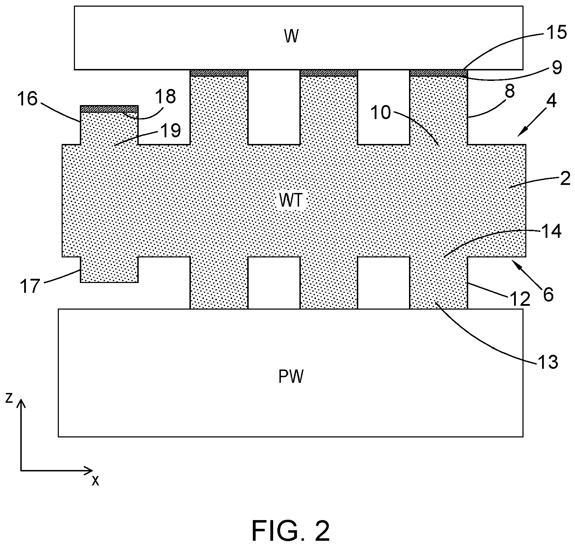

In the following description there may be cases, where there are multiple instances of substantially the same features. In the accompanying Figures 2-5D, only a single instance of each feature will be labelled in the interests of clarity.

Figure 2 schematically illustrates a portion of a known substrate support WT holding the substrate W and second positioner PW. The substrate support WT comprises a first surface 4, configured to support a substrate W and a second surface 6, opposite to the first surface.

The first surface 4 is partially defined by projections, comprising first burls 8, configured to support the substrate W, and first vacuum seals 16 configured to enable generation of a vacuum between the substrate W and the substrate support WT. The first burls 8 each comprise a distal portion 9 and proximal portion 10. The first vacuum seals 16 each comprise a distal portion 18 and a proximal portion 19. The proximal portions 10, 19 of the first burls 8 and the first vacuum seals 16 adjoin a main body 2 of the substrate support WT. The distal portions 9 of the first burls 8 are configured to directly contact substrates (e.g., substrate W).

The distal portions 9, 18 of the first burls 8 and first vacuum seals 16 comprise a top material layer or a coating 15. The coating 15 may comprise diamond-like carbon (DLC). For example, the coating 15 may comprise a carbon content more than 90% sp3-hybridized carbon. In an alternative, the coating 15 may be substantially composed of Chromium Nitride (CrN). In another alternative, the coating 15 may comprise diamond, for example monocrystalline or polycrystalline diamond. In some embodiments, the coating 15 may be up to 1000 nm thick. In an example, the coating 15 may be around 500 nm thick.

The first vacuum seals 16 project from the main body 2 to a lesser extent than the first burls 8. In an example, the first burls 8 may project around 1 to 10 µm further in the z direction than the vacuum seals 16. In another example, the first burls 8 may project around 10 to 25 µm further in the z direction than the vacuum seals 16.

The second surface 6 is partially defined by projections, comprising second burls 12 configured to support the substrate support WT on the second positioner PW, and second vacuum seals 17 configured to enable generation of a vacuum between the second positioner PW and the substrate support WT. The second burls 12 each comprise a distal portion 13 and proximal portion 14. The proximal portions 14 of the second burls 12 adjoin the main body 2 of the substrate support WT. The distal portions 13 of the second burls 12 are configured to directly contact the second positioner PW. The second vacuum seals 17 project from the main body 2 to a lesser extent than the second burls 12.

In the embodiment of substrate support WT described with reference to Figure 2, the material layers or coatings that are provided at the first burls 8 and first vacuum seals 16 are not provided on the second burls 12 and the second vacuum seals 17. In an alternative, a similar or a same material layer or coating (for example, a coating comprising DLC, chromium nitride, or diamond) may be provided over at least a part of the second surface 6. Provision of a coating at the second surface 6 may be desirable in order to compensate for stresses induced at the first surface 4 by the coating 15.

In use, the substrate support is configured to generate regions below ambient pressure (i.e., a vacuum) between the substrate W and the first surface 4 and between the second positioner PW and the second surface 6. When holding the substrate W and connected to the second positioner PW, the first vacuum seals 16 and second vacuum seals 17 are configured to define a constriction against free leakage from an ambient environment around the substrate support WT into the regions between the substrate W and the first surface 4 and between the second positioner PW and the second surface 6, enabling more efficient generation of a vacuum.

The pressure difference between the ambient environment and the regions below ambient pressure results in a clamping force (approximately normal to the plane of the substrate W and second positioner PW), pressing the substrate W and second positioner PW against the substrate support.

The substrate support WT utilizing vacuum clamping may also be referred to as a vacuum clamp.

Alternatively, the substrate W may clamped to the substrate support electrostatically. The substrate support WT may comprise an electrode layer arranged to provide a electrostatic force, e.g., an electrostatic clamping force. Electrostatic clamping of the substrate may be applied in low-pressure (e.g., vacuumized) environments. A substrate support WT utilizing electrostatic clamping may also be referred as an electrostatic clamp. These electrostatic clamps may not comprise the vacuum seals 16, 17.

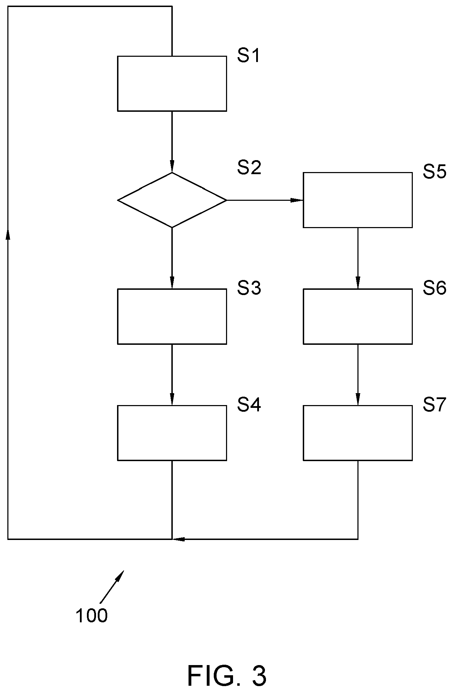

Figure 2 (and Figures 3 to 5) depict schematic illustrations of substrate supports WT. A finite number of burl 8, 12 is depicted. Though the skilled person will appreciate that the substrate support WT may comprise hundreds or thousands of burls 8, 12 arranged to support the substrate. The finite number is used for clarity and does not limit the scope of the invention. The same applies for the vacuum seals 16, 17.

Figure 3 schematically illustrates a method 100 of using and refurbishing the substrate support WT according to an embodiment of the disclosure.

At a step S1, the substrate support WT is used in a lithographic apparatus LA. After use for holding a plurality of substrates, the used substrate support WT is unsuitable for further use in the lithography apparatus due to wear at the first surface 4. In particular, the distal portions 9 of the first burls 8 and first vacuum seals 16 may be worn from direct contact with the plurality of substrates.

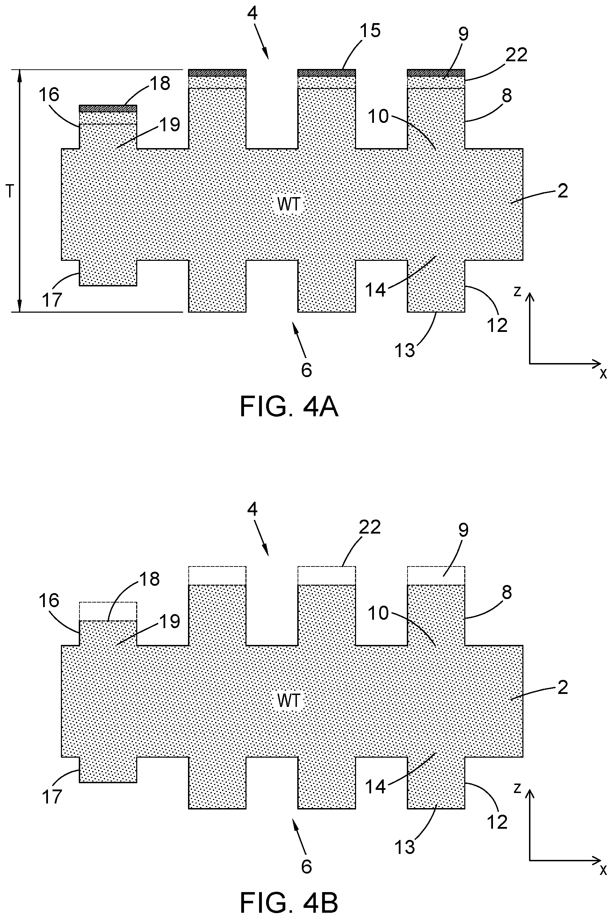

At a step S2, it is determined whether the used substrate support WT is suitable for refurbishment. This determination may comprise inspecting the thickness (indicated by dimension T of Figures 4A-C) of the substrate support WT. If the substrate support has a thickness greater than a minimum thickness, then the method proceeds to step S3.

At a step S3, material is removed from the first surface 4. Removing material from the first surface 4 comprises fine-lapping the first surface 4. The substrate support WT is schematically depicted before and after fine-lapping in Figures 4A and 4B, respectively. Fine-lapping may also be referred to as polishing or lapping. Fine-lapping removes worn portions 22 (indicated by dotted lines in Figures 4A and 4B) of the first burls 8 and first vacuum seals 16 (this may include the coating 15).

The worn portions 22 removed may be a few micrometers in thickness. In some instances, 1 µm or more of material may be removed. For example, at least 3 µm of material may be removed in order to ensure complete removal of worn portions 22. Where this is the case, there may be a risk that some worn portions are not fully removed.

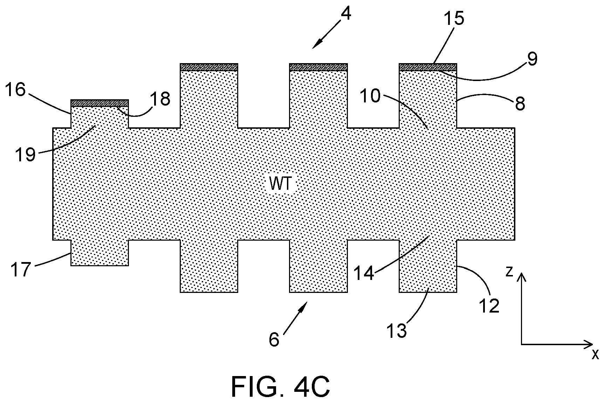

At a step S4, a new coating 15 is deposited at the distal portions 9 of the first burls 8 and at the distal portions 18 of the first vacuum seals 16 (see Figure 4C), yielding a refurbished substrate support WT suitable for reuse in a lithographic apparatus LA at a step S1. The new coating 15 may be up to 1000 nm thick. The coating 15 may be a low friction / low wear coating. For example the material layer, or coating 15, deposited may comprise, for example, DLC, CrN, or diamond. The coating 15 may comprise a wear-resistant material having a hardness of more than 6 GPa. Preferably, the material has a hardness of more than 20 GPa. Diamond-like carbon, chromium nitride, and diamond are known wear-resistant materials.

Because the thickness removed at step S3 is typically greater than the thickness restored by the newly provided coating 15 at step S4, the total thickness of the substrate support WT is reduced each time the substrate support WT is refurbished according to steps S2-4.

In an example, for some lithographic apparatuses the substrate support WT can only be refurbished according to steps S2-4 two or three times before it is below the minimum thickness. The minimum thickness is the thickness of the substrate support WT below which a further refurbishment would result in a substrate support WT too thin to hold a substrate W of standard thickness (e.g., 750-800µm). If the substrate support WT is too thin, then an upper surface of the substrate W is not in the plane of one or more sensors of a substrate stage (for example second positioner PW) which holds the substrate support WT. This may prevent proper function of the one or more sensors. A substrate support WT below the minimum thickness may also cause a step between the upper surface of the substrate W and outer parts of the substrate stage. Such a step may prevent correct operation of a system that provides immersion liquid used for immersion lithography.

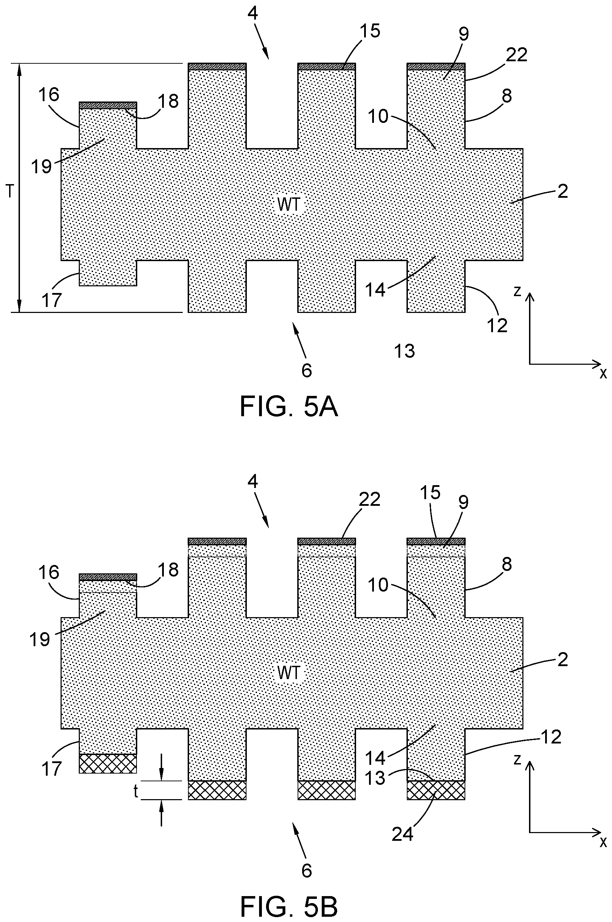

At a step S2, where it is determined that the (used) substrate support WT thickness T is below the minimum thickness, the method proceeds to a step S5 (with reference to Figure 5A).

At a step S5, a material is deposited on the second surface 6 to form a coating layer 24 with a thickness t (with reference to Figure 5B), which increases the overall thickness of the substrate support WT. Figure 5B schematically depicts the substrate support WT after deposition of the coating layer 24. The coating layer 24 may comprise the same or similar material as used to form the main body 2 of the substrate support WT and or the second burl 12. For example, the deposited material may comprise silicon carbide. The coating layer 24 may be selectively deposited at the distal portions 13 of the second burls 12, for example by means of a mask. Consequently, the distal portions 13 of the second burls 12 comprise a coating layer 24 configured to directly contact the second positioner PW.

In some embodiments the thickness t of coating layer 24 is at least 1 µm. This may be sufficient to increase the substrate support thickness above the minimum thickness in some circumstances (for example, if the refurbishment will remove only a small amount of material). In other embodiments the thickness t of coating layer 24 may be at least 3 µm. This allows at least 3 µm of material to be removed from the first surface 4 (so as to ensure removal of any worn portions) without a reduction in substrate support thickness. The thickness t of coating layer 24 may be up to 50 µm. Removing more than 50 µm of material may be problematic because the corresponding reduction in the height of the first burls 8 may be such that generation of a vacuum under the substrate W in use becomes difficult. However, the thickness t of coating layer 24 may be greater than 50 µm, e.g., up to 300 µm. Where such a thickness is provided, some material may be removed from the areas of first surface 4 between the first burls 8, so as to recover at least some of the height of the first burls 8.

In some embodiments of the method, the material of the coating layer 24 (e.g., silicon carbide) may be deposited by physical vapour deposition. In an example, silicon carbide may be deposited on the second surface 6 to form the coating layer 24 by sputter deposition. Sputter deposition can be performed at low temperatures, and reduces the thermal stresses induced in the substrate support WT during the deposition and thereafter. In some embodiments of the method, an intermediate layer or pretreatment may be deposited before deposition of coating layer 24 in order to reduce the stress induced in the substrate support WT and improve adhesion of the coating layer 24 to the substrate support WT.

In other embodiments of the method, the material of the coating layer 24 (e.g., silicon carbide) may be deposited by chemical vapour deposition. Chemical vapour deposition is typically performed at higher temperatures than sputter deposition, but this technique or process is capable of depositing material to form thicker coating layers and can be applied uniformly at multiple different surfaces of the same part.

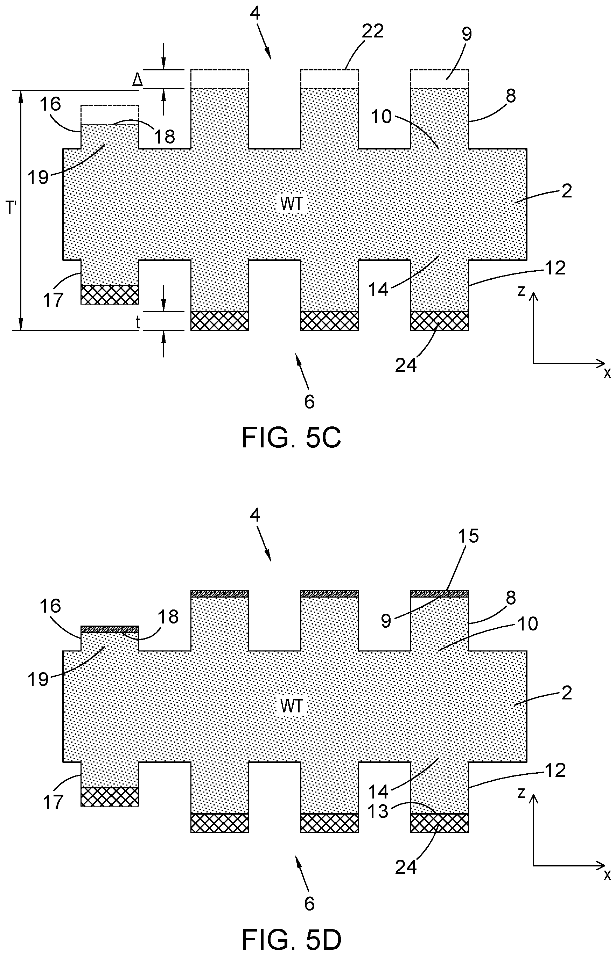

At a step S6, material is removed from the first surface 4. Removing material from the first surface 4 comprises fine-lapping the first surface to remove the worn portions 22 on the first surface (typically a few micrometers thick), with reference to Figures 5B and 5C. The worn portions 22 removed may be a few micrometers in thickness. In some instances, 1 µm or more of material may be removed. Where this is the case, there may be a risk that some worn portions are not fully removed. For example, at least 3 µm of material may be removed in order to ensure complete removal of worn portions 22.

The substrate support WT is schematically depicted before and after fine-lapping in Figures 5B and 5C, respectively. The thickness removed Δ is smaller than thickness t added by the coating layer 24, such that the resultant thickness T' at a step S6 of the substrate support WT is greater than the thickness T of the substrate support WT at step S2 (see Figure 5C).

At a step S7, a new coating 15 is deposited at the distal portions 9, 18 of the first burls 8 and the first vacuum seals 16 (see Figure 5D), yielding a refurbished substrate support WT having a final thickness greater than its thickness at step S2. The coating may be a low friction / low wear coating. The material layer that forms the new coating 15 may comprise, for example, DLC, CrN, or diamond. The new coating 15 may comprise a wear-resistant material having a hardness of more than 6 GPa. Preferably, the material has a hardness of more than 20 GPa. The refurbished substrate support WT is suitable for reuse in a lithographic apparatus LA at a step S1.

In some embodiments of the method, the coating layer 24 at the distal end 13 of the second burls 12 may also be fine-lapped after step S5, in order to achieve a desired standard of surface flatness and finish at the coating layer 24. In such embodiments the thickness of the coating layer 24 may be increased to compensate for material removal during fine-lapping of the coating layer 24.

Steps S5 and S6 may be performed in reverse order - such that the first surface 4 is removed before the material is deposited on the second surface 6.

In the method 100 described with respect to Figures 3-5D, the coating layer 24 is compliant with the receiving surface material. In general, the material deposited on the second surface to form a coating layer may comprise the same material as the second surface of the substrate support (e.g., silicon carbide). In an alternative, the coating layer may be composed of silicon dioxide or silicon nitride. Other coating materials may be used, including ceramics. The coating materials, e.g., ceramics, may have a coefficient of thermal expansion up to a value similar to silicon.

In the method 100 described with respect to Figures 3-5D, the coating layer 24 is formed by selective deposition of material (for example, silicon carbide) at the distal portions 13 of the second burls 12. In other embodiments, the material may be deposited uniformly over the second surface 6 to form a uniform coating layer. That is, material may be deposited between the second burls 12 as well as onto the second burls. Optionally, portions of the uniform coating layer may be selectively removed from areas between the second burls 12, such that the coating layer is only present at the distal portions 13 of the second burls 12. Removal of deposited material between the burls 12 may be preferred to lower stress within the substrate support WT. Methods of selective removal of portions of the uniform coating layer may include direct laser ablation and dry-etching. Different techniques may be used to remove material between the burls 12.

In some embodiments, a further coating may be formed by depositing material on the first surface 4. By depositing material all over the substrate support WT, both the first surface 4 and the second surface 6 may be uniformly coated, increasing the thickness of the substrate support WT at both the first and second surfaces 4, 6. The coating and the further coating may be the same material.

The method 100 described with respect to Figures 3-5D may also be used to modify the thickness of a substrate support. For example, the substrate support WT may be modified to allow use of substrates W, which are thinner than standard. In order to hold such substrates W such that target portions of the substrates are within the focal plane of the projection system PS, the substrate support WT may be thickened by deposition of, for example, silicon carbide on the second surface to form a coating layer, as described above. In an example, the coating layer may be up to 200 µm thick.

A person skilled in the art will appreciate that removal of material at, for example, the first surface 4 may be done by grinding and or etching of the surface of interest. These techniques may be used in combination with lapping (fine-lapping or polishing) to the first surface 4.

After deposition of the material at the first surface 4 (the new coating 15) the newly formed burl surfaces may be flattened by ion beam figuring (IBF), or reactive ion etching (RIE).

It will be appreciated that a cleaning step or action may be used to clean the first surface 4 and or the second surface 6 before a material is deposited to the surface 4, 6. Cleaning the surface 4, 6 promotes the adhesion of the deposited material with the receiving surface. A hydrogen plasma or an oxygen plasma treatment may be used before the material deposition.

In some instances, no burls at the second surface 6 of the substrate support WT are provided. Similar as surfaces comprising burls, a material layer may be deposited at the planar surface such that the substrate support is compatible with the lithographic apparatus. Hence, the method as disclosed is not limited to substrate supports comprising burls at the first and the second surface.

Although specific reference may be made in this text to the use of a lithographic apparatus in the manufacture of ICs, it should be understood that the lithographic apparatus described herein may have other applications. Possible other applications include the manufacture of integrated optical systems, guidance and detection patterns for magnetic domain memories, flat-panel displays, liquid-crystal displays (LCDs), thin-film magnetic heads, etc.

Although specific reference may be made in this text to embodiments of the invention in the context of a lithographic apparatus, embodiments of the invention may be used in other apparatus. Embodiments of the invention may form part of a mask inspection apparatus, a metrology apparatus, or any apparatus that measures or processes an object such as a wafer (or other substrate) or mask (or other patterning device). These apparatus may be generally referred to as lithographic tools. Such a lithographic tool may use vacuum conditions or ambient (non-vacuum) conditions.

Although specific reference may have been made above to the use of embodiments of the invention in the context of optical lithography, it will be appreciated that the invention, where the context allows, is not limited to optical lithography and may be used in other applications, for example imprint lithography.

Aspects of the invention are set out in the clauses below.
1. A method of refurbishing a substrate support, the substrate support comprising:
   a first surface, configured to support a substrate; and
   a second surface, opposite to the first surface ;
   the method comprising:
      depositing a material on the second surface to form a coating layer which increases a thickness of the substrate support; and
      removing material from the first surface.
2. The method of clause 1 wherein the material is removed from the first surface after depositing the material on the second surface.
3. The method of any preceding clause wherein the coating layer is at least 1 µm thick.
4. The method of any preceding clause, wherein the coating layer is up to 300 µm thick.
5. The method of any preceding clause wherein the second surface is partially defined by projections, configured to support the substrate support.
6. The method of clause 5 wherein the material is deposited selectively on the projections of the second surface.
7. The method of any preceding clause wherein the material is deposited uniformly over the second surface.
8. The method of clause 7 wherein the method further comprises selectively subtracting portions of the coating layer.
9. The method of any preceding clause wherein removing material from the first surface comprises fine-lapping the first surface.
10. The method of clause 9 wherein the method comprises depositing a wear-resistant material having a hardness of at least 6 GPa on at least a portion of the first surface.
11. The method of clause 9 wherein the method comprises depositing a wear-resistant material having a hardness of at least 20 GPa on at least a portion of the first surface.
12. The method of clause 9, 10, or 11 wherein the method comprises depositing a diamond-like carbon coating, a chromium nitride coating, or a diamond coating on at least a portion of the first surface.
13. The method of any of clauses 10 to 12, wherein the first surface is flattened by ion beam figuring or reactive ion etching after deposition of the (wear-resistant) material at the first surface.
14. The method of any preceding clause wherein the method further comprises fine-lapping the coating layer.
15. The method of any preceding clause, wherein the material deposited on the second surface to form a coating layer comprises the same material as the second surface of the substrate support.
16. The method of any preceding clause, wherein the material deposited on the second surface to form a coating layer comprises material compliant to the second surface of the substrate support.
17. The method of any preceding clause, wherein the material deposited on the second surface to form a coating layer is Silicon Carbide.
18. The method of any preceding clause, further comprising cleaning of first and or second surface before material deposition.
19. The method of clause 18, wherein cleaning is by means of a hydrogen or an oxygen plasma.
20. The method of any preceding clause wherein the material is deposited by physical vapour deposition.
21. The method of clause 20 wherein the material is deposited by sputter deposition.
22. The method of any of clauses 1-19 wherein the material is deposited by chemical vapour deposition.
23. A substrate support comprising:
   a first surface, configured to support a substrate;
   a second surface, opposite to the first side; and
   a coating layer overlying at least part of the second surface.
24. The substrate support of clause 23, wherein the coating layer comprises the same material as the second surface of the substrate support.
25. The substrate support of clauses 23 or 24, wherein the coating layer is Silicon Carbide.
26. A substrate support, wherein the substrate support is refurbished according to the method of any of clauses 1 to 22.

While specific embodiments of the invention have been described above, it will be appreciated that the invention may be practiced otherwise than as described. The descriptions above are intended to be illustrative, not limiting. Thus it will be apparent to one skilled in the art that modifications may be made to the invention as described without departing from the scope of the claims set out below.

## Claims

1. A method of refurbishing a substrate support, the substrate support comprising:
a first surface, configured to support a substrate; and
a second surface, opposite to the first surface;
the method comprising:
depositing a material on the second surface to form a coating layer which increases a thickness of the substrate support; and
removing material from the first surface.

2. The method of claim 1 wherein the material is removed from the first surface after depositing the material on the second surface.

3. The method of any preceding claim wherein the coating layer is at least 1 µm thick.

4. The method of any preceding claim, wherein the coating layer is up to 300 µm thick.

5. The method of any preceding claim wherein the second surface is partially defined by projections, configured to support the substrate support.

6. The method of claim 5 wherein the material is deposited selectively on the projections of the second surface.

7. The method of any preceding claim wherein the material is deposited uniformly over the second surface.

8. The method of claim 7 wherein the method further comprises selectively subtracting portions of the coating layer.

9. The method of any preceding claim wherein removing material from the first surface comprises fine-lapping the first surface.

10. The method of claim 9 wherein the method comprises depositing a wear-resistant material having a hardness of at least 6 GPa on at least a portion of the first surface.

11. The method of claim 9 or 10 wherein the method comprises depositing a diamond-like carbon coating, a chromium nitride coating, or a diamond coating on at least a portion of the first surface.

12. The method of claim 10 or 11, wherein the first surface is flattened by ion beam figuring or by reactive ion etching after deposition of the material at the first surface.

13. The method of any preceding claim, wherein the material deposited on the second surface to form a coating layer comprises material compliant to the second surface of the substrate support.

14. The method of any preceding claim, wherein the material deposited on the second surface to form a coating layer is Silicon Carbide.

15. A substrate support, wherein the substrate support is refurbished according to the method of any of claims 1 to 14.
